# FASCICULE DE BREVET EUROPEEN

(11) **EP 0 309 323 B1**
(45) Date de publication et mention de la délivrance du brevet: **20.01.1993**
(21) Numéro de dépôt: 88402335.9
(22) Date de dépôt: 16.09.1988
(51) Int. Cl.: H01L 39/24, C04B 33/30, C04B 35/50

(54) **Procédé de préparation de supraconducteurs et produits ainsi obtenus**
Verfahren zur Herstellung von Supraleiter und hiermit erhaltene Produkte
Process of manufacturing superconductors and therewith obtained products

(30) Priorité: 18.09.1987 FR 8712935
(43) Date de publication de la demande: 29.03.1989
(73) Titulaire: RHONE-POULENC CHIMIE, 92408 Courbevoie Cédex (FR)
(72) Inventeur: Lafon, Marie-Odile, F-75004 Paris (FR); Magnier, Claude, F-75019 Paris (FR)
(74) Mandataire: Dubruc, Philippe

(56) Documents cités:
- GB-A- 2 017 523
- ADVANCED CERAMIC MATERIALS- CERAMIC SUPERCONDUCTORS vol. 2, no. 3B, juillet 1987, pages 444-456, Westerville, US; G.W. CRABTREE et al.: "Fabrication, mechanical properties, heat capacity, oxygen diffusion and the effect of alkali earth ion substitution on high Tc superconductors"
- JAPANESE JOURNAL OF APPLIED PHYSICS, vol. 26, no. 5, mai 1987, pages L734-L735, Tokyo, JP; K. KANEKO et al.: "In the coprecipitation method for the preparation of high Tc M-X-Cu-O (M=Ba, Sr, X=La, Y) system"
- JAPANESE JOURNAL OF APPLIED PHYSICS, vol. 26, no. 7, juillet 1987, pages L1159-L1160, Tokyo, JP; M. FUJIKI et al.: "Preparation of a high-Tc Y-Ba-Cu-O superconductor using colloidal methods"
- JOURNAL OF THE AMERICAN CERAMIC SOCIETY, vol. 70, no. 12, décembre 1987, pages C375-C377, Westerville, USA; C.-T. CHU et al.: "Preparation of high-Tc superconducting oxides by the amorphous citrate process"

## Description

La présente invention a trait au domaine des matériaux supraconducteurs.

On sait que la supraconductivité se caractérise entre autre par la disparition de toute résistance électrique dans un corps porté à très basse température.

Jusqu'à un passé récent, l'état supraconducteur dans certains matériaux n'apparaissait qu'en-dessous d'une température seuil, dite "température critique", généralement proche du zéro absolu. Une telle contrainte a constitué à l'évidence un frein sérieux au développement sur une grande échelle de toutes les applications pratiques potentielles pouvant découler de la supraconductivité.

Or, depuis peu, des recherches ont permis de mettre en évidence de nouveaux matériaux qui présentent des propriétés supraconductrices à plus hautes températures, c'est-à-dire des températures s'étalant de 70 à 90°K, voire jusqu'à 100°K.

Ces matériaux sont pour la plupart à base de terres rares, d'alcalino-terreux, de métaux de transition et d'oxygène. Plus spécifiquement, les systèmes étudiés les plus prometteurs semblent être ceux à base d'yttrium et/ou lanthane, de baryum et/ou de strontium et/ou de calcium, de cuivre et/ou de nickel et/ou de cobalt et/ou de manganèse, et d'oxygène.

La méthode de synthèse généralement décrite dans la littérature pour aboutir à ces matériaux repose sur une réaction en phase solide, à hautes températures (1 000°C) entre des oxydes et/ou des sels contenant un anion volatil (par exemple le carbonate) des éléments correspondants, ces derniers composés se présentant sous forme de poudres (par exemple : "Advanced Ceramic Materials", vol.2, no. 3B, juillet '87, pp. 444-456)

Toutefois, ce procédé présente l'inconvénient d'être d'un contrôle délicat et conduit à des poudres dont l'aptitude au frittage peut paraître insuffisante.

Or, au niveau de certaines applications pratiques, seule l'utilisation des produits frittés supraconducteurs présente un intérêt réel.

Il est donc essentiel de pouvoir disposer de matériaux frittés, denses et homogènes ayant conservé les propriétés intrinsèques de supraconductivité des poudres de départ. Il en découle la nécessité de disposer tout d'abord de poudres supraconductrices homogènes présentant de bonnes aptitudes au frittage.

La présente invention a donc pour but de résoudre les problèmes ci-dessus et de proposer des moyens simples, efficaces et de mise en oeuvre aisée, pour obtenir de manière reproductible tant des poudres supraconductrices homogènes présentant une excellente aptitude au frittage que des matériaux frittés supraconducteurs de haute densité.

On a maintenant trouvé, et il s'agit là d'un des premiers objets de la présente invention, que l'on peut obtenir des poudres fines supraconductrices et frittables au moyen du procédé de préparation selon l'invention, ledit procédé étant caractérisé en ce qu'il comprend les étapes suivantes :
a) on mélange d'une part un sol de terre rare et d'autre part une solution d'au moins un nitrate d'alcalino-terreux et d'au moins un nitrate d'un métal de transition, le pH du mélange obtenu étant ajusté à une valeur telle que lesdits nitrates restent à l'état soluble dans ce mélange ;
b) on opère ensuite le séchage du mélange obtenu ;
c) on calcine le produit séché ;
d) on opère éventuellement le broyage de la poudre calcinée.

Dans l'exposé qui suit de la présente invention, on entend par terre rare d'une part tout élément du Tableau Périodique dont le numéro atomique est compris, inclusivement, entre 57 et 71, et d'autre part l'yttrium qui, par convention, est assimilé ici à une terre rare.

D'autre part, on entend par "terres rares yttriques" les éléments les plus lourds des terres rares, conformément au numéro atomique, commençant avec le samarium et finissant avec le lutécium et comprenant l'yttrium.

Enfin, on entend ici par "sol" tout système composé de fines particules colloïdales solides, en dispersion dans une phase aqueuse.

D'une manière générale, les sols de terres rares qui sont utilisés dans la présente invention peuvent être préparés par tout moyen connu en soi, notamment selon un procédé tel que décrit dans le brevet US-A- 3 024 199, c'est à dire par peptisation thermique de l'oxyde de terre rare hydraté correspondant.

Plus particulièrement, lorsqu'il s'agit de préparer des sols de terre rare du type yttrique, on pourra opérer selon un procédé tel que décrit dans la demande de brevet français déposée sous le n° 87 12669 et non-publiée avant la data de dépôt.

Selon ce procédé, on fait d'abord réagir, sous agitation et à température ambiante, d'une part un oxyde de terre rare avec d'autre part une quantité contrôlée d'un acide monovalent, soluble dans l'eau et présentant un pKa compris entre 2,5 et 5,0 comme par exemple l'acide acétique, puis on chauffe le milieu réactionnel ainsi obtenu jusqu'à une température comprise entre 70°C et 100°C, et on maintient cette température pendant 1 à 4 heures, de préférence pendant 3 à 4 heures.

Le procédé décrit dans ce document comprend en outre de préférence les caractéristiques suivantes :
- l'oxyde de terre rare (par exemple Y₂O₃) se présente sous la forme d'une poudre fine de haute pureté (supérieure à 99 %) dont la taille des particules est de l'ordre de quelques microns, ledit oxyde ayant été préalablement calciné à une température comprise entre 850°C et 1050°C, de préférence aux environs de 950°C, pendant un temps compris entre 2 et 4 heures.
- on utilise une solution d'acide acétique concentrée entre 1 et 4N, et en une quantité telle qu'elle soit en défaut par rapport à la stoechiométrie, ce qui signifie que le rapport molaire entre l'acide mis en oeuvre et l'oxyde de terre rare exprimé en cation métallique est inférieur à 2,5, de préférence choisi aux environs de 1,5.
- l'oxyde de terre rare n'ayant éventuellement pas réagi est éliminé par filtration, décantation ou centrifugation.

La présente invention se réfère à un procédé de préparation d'une poudre fine supraconductrice comme defini dans la revendication 1.

Selon un mode préférentiel de réalisation de la présente invention, on opère avec des sols d'yttrium ou des sols de lanthane. Selon un mode de réalisation encore plus préféré, on travaille avec des sols d'yttrium.

Selon le procédé de l'invention, on mélange alors au sol une solution soluble dans l'eau d'au moins un nitrate d'alcalino-terreux et d'au moins un nitrate d'un métal de transition.

Les nitrates d'alcalino-terreux utilisables dans le présent procédé sont principalement les nitrates de calcium, de baryum et de strontium.

Parmi les nitrates des métaux de transition, on peut choisir notamment les nitrates de cuivre, de nickel, de manganèse, de cobalt et de fer.

Le choix des sols et des nitrates au sein des familles ci-dessus se fera bien entendu en fonction de la nature et de la composition de la poudre supraconductrice que l'on désire obtenir.

De même, les proportions entre les divers composés de départ sont ajustées classiquement en fonction de la stoechiométrie désirée dans le produit final, celle-ci devant naturellement correspondre à l'obtention des propriétés supraconductrices.

Le procédé selon l'invention s'applique ainsi particulièrement bien à la fabrication des systèmes supraconducteurs du type Y-Ba-Cu-O. Ces systèmes ont été décrits notamment dans un article paru dans le Journal of American Chemical Society, 1987, 109, 2528-2530.

Selon une caractéristique essentielle du procédé de l'invention, on s'arrange pour que le pH du mélange obtenu soit ajusté à une valeur telle que les nitrates restent à l'état soluble, c'est-à-dire ne précipitent pas. Cet ajustement se fait notamment par ajout d'acide, de préférence de l'acide nitrique ou de l'acide acétique.

Selon un mode particulier de réalisation de l'invention, on acidifie d'abord la solution initiale de nitrates au moyen d'acide nitrique ou d'acide acétique, puis on ajoute dans cette solution acidifiée le sol de terre rare, la quantité d'acide introduite dans la solution de nitrates devant être suffisante pour permettre l'obtention, après ajout du sol, d'un pH final inférieur au pH de précipitation des nitrates dans le mélange.

A titre d'exemple, dans le cas d'un système sol d'yttrium-nitrate de baryum-nitrate de cuivre, cette valeur critique de pH se situe aux environs de 4,1.

Le mélange ainsi obtenu contient environ 10 à 30 % en poids de matière sèche. Il doit ensuite être séché.

Ce séchage pourra se faire par tout moyen connu, notamment par atomisation, c'est-à-dire par pulvérisation du mélange dans une atmosphère chaude.

Préférentiellement, on réalise ce séchage dans un réacteur "flash", par exemple du type mis au point par la Demanderesse et décrit notamment dans les brevets français n° 2 257 326, 2 419 754 et 2 431 321. Dans ce cas, les gaz traitants sont animés d'un mouvement hélicoïdal et s'écoulent dans un puits-tourbillon. Le mélange est injecté suivant une trajectoire confondue avec l'axe de symétrie des trajectoires hélicoïdales des gaz ce qui permet de transférer parfaitement la quantité de mouvement des gaz aux particules dudit mélange. Les gaz assurent ainsi une double fonction : d'une part la pulvérisation, c'est à dire la transformation en fines gouttelettes, de la suspension, et d'autre par le séchage des gouttelettes obtenues. Par ailleurs, le temps de séjour des particules dans le réacteur est extrêmement faible, il est inférieur à 1/10 de seconde environ, ce qui supprime tout risque de surchauffe par suite d'un contact trop long avec les gaz.

Selon les débits respectifs des gaz et du mélange, la température d'entrée des gaz est comprise entre 600°C et 900°C, de préférence comprise entre 700° et 900°, et la température de sortie du solide séché comprise entre 100°C et 300°C, de préférence entre 150°C et 250°C.

On obtient un produit sec présentant une granulométrie de l'ordre de quelques microns, comprise entre 1 et 10 microns par exemple.

Le produit est ensuite calciné.

La calcination est opérée à une température comprise entre 700°C et 1 000°C, de préférence comprise entre 800°C et 900°C. La durée de la calcination peut varier entre 30 min et 24 heures par exemple, et de préférence entre 5 et 15 heures.

Cette calcination est conduite sous atmosphère d'air ou tout mélange air/oxygène, mais de préférence sous air.

D'autre part, selon un mode particulier de réalisation de l'invention, les produits calcinés sont refroidis très rapidement jusqu'à température ambiante, opération équivalente à une trempe, par exemple au moyen d'un balayage d'air froid.

Le temps de refroidissement est généralement de l'ordre de quelques secondes.

A la suite de cette calcination, on obtient une poudre supraconductrice présentant une granulométrie macroscopique de 1 à 10 µm (microns) environ, les grains de 1 à 10 µm étant constitués de cristallites élémentaires de taille comprise entre 0.01 µm (100 Å) et 0.06 µm (600 Å) environ.

Les poudres obtenues doivent généralement être broyées, de préférence à sec, de manière à pouvoir conduire un bon frittage. La répartition granulométrique moyenne des poudres se situe alors entre environ 0,5 et 2 µm (microns), de préférence entre 1 et 2 µm.

Ces poudres supraconductrices présentent la propriété remarquable de pouvoir donner, après frittage, des matériaux frittés supraconducteurs, parfaitement homogènes, et dont la densité est supérieure à 96 % de la densité théorique du matériau considéré.

La température de frittage des poudres est comprise entre 900°C et 1 000°C, et le temps de frittage généralement compris entre 2 et 10 heures. De préférence, le frittage est réalisé sous atmosphère d'oxygène.

Plus spécifiquement, les caractéristiques des poudres supraconductrices selon l'invention, au regard de leur aptitude au frittage, sont déterminées de la façon suivante :
la poudre est tout d'abord pastillée avec ou sans liant, sous une pression uniaxiale de 1,5x10³kg/cm² (T/cm²), puis frittée pendant 2 heures à une température de 950°C et refroidi en 7 heures jusqu'à température ambiante ; on mesure alors la densité du produit obtenu. Dans tous les cas, on observe une densité finale supérieure à 95 % de la densité théorique du matériau considéré.

D'autre part, on observe que le produit fritté obtenu présente de très bonnes propriétés supraconductrices.

D'autres avantages et aspects de l'invention apparaitront à la lecture de l'exemple qui suit.

### Exemple

Cet exemple illustre l'invention dans le cadre de la préparation d'un matériau supraconducteur de formule Y-Ba₂-Cu₃-Oₓ (6,5 ≦ x ≦ 7).
A - Préparation de la poudre
Dans 800 ml d'eau à 70°C, on dissout 76,8 g de nitrate de baryium et 106,6 g de nitrate de cuivre.
On acidifie cette solution avec 27 ml d'acide acétique concentré.
On introduit ensuite dans ce mélange, sous agitation, 100 ml d'un sol d'yttrium concentré à 166 g/l en oxyde d'yttrium. Ce sol a été préparé conformément au procédé tel que décrit dans la demande de brevet français n° 87 12669
Après homogénéisation, la suspension obtenue est séchée par atomisation.
Le séchage a lieu dans un réacteur de type "flash", tel que décrit dans les brevets français n° 2 257 326, 2 419 754 et 2 431 321.
La température d'entrée des gaz est de 800°C, leur température de sortie de 200°C.
La poudre obtenue après séchage est ensuite calcinée à 850°C sous air pendant un temps compris entre 10 et 15 heures.
Puis on effectue un broyage à sec jusqu'à l'obtention d'une poudre dont la granulométrie moyenne est inférieure à 2 µm.
Les charactéristiques de la poudre obtenue sont alors les suivantes :

| | |
|---|---|
| - surface spécifique (BET) | 3 m²/g |
| - volume poreux total | 0,38 cm³/g |
| dont un volume réel | 0,28 cm³/g |
| et un volume intergranulaire | 0,10 cm³/g |
| - domaine de porosité | 0,02-10 µm |
| - diamètre moyen des pores | 0,6 µm |
| - granulométrie moyenne | 1,3 µm |
| - taille moyenne des cristallites | environ 0.04 µm (400 Å) |

La répartition granulométrique des grains est la suivante (⌀ = diamètre) :

| | |
|---|---|
| - ⌀ > 4 µm | 20 % |
| - 0,7 µm < ⌀ < 4 µm | 60 % |
| - ⌀ < 0,7 µm | 20 %. |

B - Frittage de la poudre
La poudre est pastillée par pressage à sec uniaxial sous une pression de 1,5 x 10³kg/cm² (T/cm²), puis frittée à 950°C pendant 2 heures sous oxygène et refroidie en 7 heures jusqu'à température ambiante.
On obtient un matériau présentant une densité égale à 96 % de sa densité théorique.
Ce matériau est supraconducteur, sa température "onset" de début de transition est de 92 K et il répond à la formule moyenne Y-Ba₂-Cu₃-O_{6,9}.

## Revendications

1. Procédé de préparation d'une poudre fine supraconductrice comportant au moins une terre rare, au moins un alcalinoterreux, un métal de transition et oxygène, comprenant les étapes suivantes :
a) on mélange d'une part un sol de terre rare et d'autre part une solution d'au moins un nitrate d'alcalino-terreux et d'un nitrate d'un métal de transition, le pH du mélange étant inférieur au pH de précipitation desdits nitrates ;
b) on opère ensuite le séchage du mélange obtenu ;
c) on calcine le produit séché ;
d) on opère éventuellement le broyage de la poudre

2. Procédé selon la revendication 1 caractérisé en ce que ledit pH est ajusté au moyen d'un ajout d'acide nitrique ou d'acide acétique.

3. Procédé selon la revendication 2 caractérisé en ce que ledit ajout se fait dans la solution de nitrates.

4. Procédé selon l'une quelconque des revendications précédentes caractérisé en ce que ledit séchage se fait par atomisation.

5. Procédé selon la revendication 4 caractérisé en ce que ladite atomisation se fait en injectant ledit mélange suivant une trajectoire confondue avec l'axe de symétrie d'un écoulement hélicoïdal et puits-tourbillon de gaz chauds pulvérisant puis séchant ledit mélange, le temps de séjour des particules dans le réacteur étant inférieur à 1/10 de seconde environ.

6. Procédé selon la revendication 5 caractérisé en ce que la température d'entrée desdits gaz chauds est comprise entre 600° et 900°C.

7. Procédé selon la revendication 6 caractérisé en ce que ladite température d'entrée est comprise entre 700° et 900°C.

8. Procédé selon l'une quelconque des revendications 5 à 7 caractérisé en ce que la température de sortie du solide séché est comprise entre 100° et 300°C.

9. Procédé selon la revendication 8 caractérisé en ce que ladite température de sortie est comprise entre 150° et 250°C.

10. Procédé selon l'une quelconque des revendications précédentes caractérisé en ce que ladite calcination s'effectue entre 700°C et 1 000°C, de préférence entre 800°C et 900°C.

11. Procédé selon l'une quelconque des revendications précédentes caractérisé en ce que la calcination s'effectue sous air.

12. Procédé selon l'une quelconque des revendications précédentes caractérisé en ce que ledit broyage s'effectue à sec.

13. Procédé selon la revendication 12 caractérisé en ce que l'on broie les produits calcinés jusqu'à une granulométrie moyenne inférieure à 2 microns.

14. Procédé selon l'une quelconque des revendications précédentes caractérisé en ce que les nitrates d'alcalino-terreux sont choisis parmi les nitrates de calcium, de strontium et de baryum.

15. Procédé selon l'une quelconque des revendications précédentes caractérisé en ce que les nitrates de métaux de transition sont choisis parmi les nitrates de cuivre, de nickel, de manganèse, de cobalt et de fer.

16. Procédé selon l'une quelconque des revendications précédentes caractérisé en ce que l'on utilise un sol de terre rare et une solution de nitrate de baryum et de nitrate de cuivre.

17. Procédé selon l'une quelconque des revendications précédentes caractérisé en ce que l'on utilise un sol d'yttrium.

## Claims

1. Process for preparing a superconducting fine powder containing at least one rare earth metal, at least one alkaline earth metal, one transition metal and oxygen, comprising the following stages:
a) on the one hand a rare earth metal sol, and on the other hand a solution of at least one alkaline earth metal nitrate and at least one transition metal nitrate, are mixed, the pH of the mixture being below the pH of precipitation of the said nitrates;
b) drying of the mixture obtained is then performed;
c) the dried product is calcined; and
d) grinding of the powder is optionally performed.

2. Process according to claim 1, characterized in that the said pH is adjusted by means of an addition of nitric acid or acetic acid.

3. Process according to claim 2, characterized in that the said addition is carried out in the solution of nitrates.

4. Process according to any one of the preceding claims, characterized in that the said drying is carried out by atomization.

5. Process according to claim 4, characterized in that the said atomization is carried out by injecting the said mixture according to a path coincident with the axis of symmetry of a helicoid and vortex-well flow of hot gases spraying and then drying the said mixture, the residence time of the particles in the reactor being less than 1/10 second approximately.

6. Process according to claim 5, characterized in that the inflow temperature of the said hot gases is between 600° and 900°C.

7. Process according to claim 6, characterized in that the said inflow temperature is between 700° and 900°C.

8. Process according to any one of claims 5 to 7, characterized in that the outflow temperature of the dried solid is between 100° and 300°C.

9. Process according to claim 8, characterized in that the said outflow temperature is between 150° and 250°C.

10. Process according to any one of the preceding claims, characterized in that the said calcination is performed at between 700°C and 1,000°C, and preferably between 800°C and 900°C.

11. Process according to any one of the preceding claims, characterized in that the calcination is performed under air.

12. Process according to any one of the preceding claims, characterized in that the said grinding is performed in the dry state.

13. Process according to claim 12, characterized in that the calcined products are ground to a mean particle size of less than 2 microns.

14. Process according to any one of the preceding claims, characterized in that the alkaline earth metal nitrates are chosen from calcium, strontium and barium nitrates.

15. Process according to any one of the preceding claims, characterized in that the transition metal nitrates are chosen from copper, nickel, manganese, cobalt and iron nitrates.

16. Process according to any one of the preceding claims, characterized in that a rare earth metal sol and a solution of barium nitrate and copper nitrate are used.

17. Process according to any one of the preceding claims, characterized in that an yttrium sol is used.

## Patentansprüche

1. Verfahren zur Herstellung eines supraleitenden, feinen Pulvers, das zumindest eine Seltene Erde, zumindest ein Erdalkali, ein Übergangsmetall und Sauerstoff enthält, umfassend die folgenden Stufen:
a) man mischt einesteils ein Seltene Erden-Sol und anderenteils eine Lösung zumindest eines Erdalkalinitrats und eines Übergangsmetallnitrats, wobei der pH der Mischung geringer als der Ausfällungs-pH der Nitrate ist;
b) man führt hiernach die Trocknung des erhaltenen Gemisches durch;
c) man calciniert das getrocknete Produkt;
d) man führt gegebenenfalls die Zerkleinerung des Pulvers durch.

2. Verfahren gemäß Anspruch 1, dadurch gekennzeichnet, daß der pH durch Zugabe von Salpetersäure oder Essigsäure eingestellt wird.

3. Verfahren gemäß Anspruch 2, dadurch gekennzeichnet, daß die Zugabe in die Lösung der Nitrate erfolgt.

4. Verfahren gemäß einem der vorhergehenden Ansprüche, dadurch gekennzeichnet, daß die Trocknung durch Zerstäuben erfolgt.

5. Verfahren gemäß Anspruch 4, dadurch gekennzeichnet, daß die Zerstäubung erfolgt, indem man das Gemisch entsprechend einer Bahn einspritzt, die verschmolzer ist mit der Symmetrieachse einer spiralförmigen Strömung und eines Wirbelschachts von das Gemisch zerstäubenden und danach trocknenden, warmen Gasen, wobei die Verweilzeit der Teilchen in dem Reaktor geringer als etwa 1/10 Sekunde ist.

6. Verfahren gemäß Anspruch 5, dadurch gekennzeichnet, daß die Eintrittstemperatur der warmen Gase zwischen 600 und 900^{o}C beträgt.

7. Verfahren gemäß Anspruch 6, dadurch gekennzeichnet, daß die Eintrittstemperatur zwischen 700 und 900^{o}C beträgt.

8. Verfahren gemäß einem der Ansprüche 5 bis 7, dadurch gekennzeichnet, daß die Austrittstemperatur des getrockneten Feststoffs zwischen 100 und 300^{o}C liegt.

9. Verfahren gemäß Anspruch 8, dadurch gekennzeichnet, daß die Austrittstemperatur zwischen 150 und 250^{o}C liegt.

10. Verfahren gemäß einem der vorhergehenden Ansprüche, dadurch gekennzeichnet, daß die Calcinierung zwischen 700 und 1000^{o}C, vorzugsweise zwischen 800 und 900^{o}C, erfolgt.

11. Verfahren gemäß einem der vorhergehenden Ansprüche, dadurch gekennzeichnet, daß die Calcinierung unter Luft erfolgt.

12. Verfahren gemäß einem der vorhergehenden Ansprüche, dadurch gekennzeichnet, daß die Zerkleinerung im Trocknen erfolgt.

13. Verfahren gemäß Anspruch 12, dadurch gekennzeichnet, daß man die calcinierten Produkte bis zu einer durchschnittlichen Korngröße von geringer als 2 Mikron zerkleinert.

14. Verfahren gemäß einem der vorhergehenden Ansprüche, dadurch gekennzeichnet, daß die Erdalkalinitrate unter den Calcium-, Strontium- und Bariumnitraten ausgewählt werden.

15. Verfahren gemäß einem der vorhergehenden Ansprüche, dadurch gekennzeichnet, daß die Übergangsmetallnitrate unter den Kupfer-, Nickel-, Mangan-, Kobalt- und Eisennitraten ausgewählt werden.

16. Verfahren gemäß einem der vorhergehenden Ansprüche, dadurch gekennzeichnet, daß man ein Seltene Erden-Sol und eine Lösung von Bariumnitrat und Kupfernitrat verwendet.

17. Verfahren gemäß einem der vorhergehenden Ansprüche, dadurch gekennzeichnet, daß man ein Yttrium-Sol verwendet.
